# DEMANDE DE BREVET EUROPEEN

(11) **EP 1 109 209 A1**
(43) Date de publication de la demande: **20.06.2001**
(21) Numéro de dépôt: 00403511.9
(22) Date de dépôt: 14.12.2000
(51) Int. Cl.: H01L 21/20, H01L 21/306, H01L 29/06, H01L 29/16, H01L 33/00, H01L 31/00

(54) **Procédé de fabrication d'un réseau de lignes nanométriques en silicium monocristallin et dispositif obtenu**

(30) Priorité: 16.12.1999 FR 9915902
(71) Demandeur: STMicroelectronics SA, 94250 Gentilly (FR); FRANCE TELECOM, 75015 Paris (FR)
(72) Inventeur: Skotnicki, Thomas, 38920 Crolles Montfort (FR); Jurczak, Malgorzata, 3001 Heverlee (BE); Dutartre, Didier, 38240 Meylan (FR)
(74) Mandataire: Casalonga, Axel

(57) **Abrégé**

Le procédé de fabrication d'un réseau de lignes nanométriques en silicium monocristallin sur un substrat isolant comprend :
(a) l'obtention d'un substrat comprenant un corps de silicium, un isolement latéral définissant dans le corps une partie centrale, un évidement formé dans la partie centrale ayant une paroi de fond en matériau diélectrique, une première paire de parois latérales parallèles opposées en matériau diélectrique et une seconde paire de parois latérales parallèles opposées, au moins une des parois latérales parallèles opposées de la deuxième paire étant constituée par du silicium monocristallin ;
(b) la croissance par épitaxie dans l'évidement, à partir de la paroi latérale en silicium monocristallin de l'évidement, d'un réseau alterné de lignes parallèles en alliage SiGe monocristallin et de lignes en silicium monocristallin ; et
(c) la gravure des lignes en alliage SiGe monocristallin, pour former dans l'évidement un réseau de lignes parallèles en silicium monocristallin isolées les unes des autres.

## Description

La présente invention concerne d'une manière générale un procédé de fabrication d'un réseau de lignes nanométriques en silicium monocristallin sur un substrat isolant.

Un réseau de lignes en silicium monocristallin sur un substrat isolant peut être une structure très intéressante pour des applications à la fabrication de transistors, mémoires, dispositifs opto-électroniques et autres.

Un réseau de lignes en silicium monocristallin sur un substrat isolant peut être obtenu naturellement par photolithographie et gravure d'un substrat de type SOI (silicium sur isolant). Toutefois, cette approche ne peut fournir que des lignes et des espacements interlignes dans la limite de résolutions du procédé de photolithogravure. Les procédés de photolithogravure permettent tout au plus d'obtenir des lignes ayant une largeur de 100 nanomètres ou plus.

Il serait donc souhaitable de disposer d'un procédé permettant l'obtention de lignes en silicium monocristallin de très faible largeur, en particulier inférieure à 100 nanomètres afin d'accroître l'intégration des dispositifs obtenus et également de favoriser les effets de transport mécaniques et opto-électroniques.

La présente invention a donc pour objet un procédé de fabrication d'un réseau de lignes nanométriques en silicium monocristallin sur un substrat isolant, en particulier de lignes nanométriques parallèles et de largeur inférieure à 100 nanomètres.

Selon l'invention, le procédé de fabrication d'un réseau de lignes nanométriques en silicium monocristallin sur un substrat isolant comprend :
a) l'obtention d'un substrat comprenant un corps de silicium monocristallin, un isolement latéral définissant dans le corps une partie centrale, un évidement formé dans la partie centrale ayant une paroi de fond en matériau diélectrique, de préférence SiO₂, une première paire de parois latérales parallèles opposées en matériau diélectrique, de préférence SiO₂, et une deuxième paire de parois latérales parallèles opposées, au moins une des parois latérales de la deuxième paire étant constituée par du silicium monocristallin ;
b) la croissance par épitaxie dans l'évidement, à partir de la paroi latérale en silicium monocristallin de l'évidement, d'un réseau alterné de lignes parallèles en alliage SiGe monocristallin et en silicium monocristallin ; et
c) la gravure des lignes en alliage SiGe monocristallin pour former dans l'évidement un réseau de lignes parallèles en silicium monocristallin isolées les unes des autres.

L'emploi de la technique de croissance épitaxiale pour la réalisation des lignes de la structure selon l'invention permet un choix pratiquement à volonté de la finesse des lignes. En outre, l'usage de la sélectivité de gravure entre l'alliage SiGe et le silicium permet une réalisation aisée du réseau de lignes de silicium monocristallin sur le substrat isolant ayant des caractéristiques dimensionnelles bien définies et pratiquement de la finesse voulue par le concepteur.

Un autre avantage important du procédé de l'invention est qu'il peut être mis en oeuvre à partir soit d'un substrat en silicium monocristallin massif soit d'un substrat dit SOI (silicium sur isolant) classique.

Dans une autre réalisation de l'invention, les deux parois latérales parallèles opposées de la deuxième paire de parois latérales de l'évidement formé dans la partie centrale du corps de silicium du substrat sont constituées par du silicium monocristallin et la croissance épitaxiale du réseau alterné de lignes parallèles en alliage SiGe monocristallin et de lignes en silicium monocristallin s'effectue à partir de ces deux parois latérales parallèles opposées.

De préférence, la largeur (finesse) des lignes alternées du réseau est de 5 à 20 nanomètres.

En raison de l'utilisation de la croissance épitaxiale pour former le réseau de lignes alternées, il est possible de choisir à volonté la périodicité des lignes en silicium monocristallin et des espaces interlignes ainsi que leur largeur. Toutefois, il faut veiller à ne pas dépasser les épaisseurs critiques (connues de l'homme du métier) pour ainsi ne pas risquer de nuire à la relaxation des contraintes des couches.

Dans une première réalisation de l'invention, le substrat de l'étape (a) est obtenu à partir d'un substrat massif en silicium monocristallin comportant un isolement latéral définissant une partie centrale du substrat massif, masquage et gravage de la partie centrale pour y former un évidement ayant une paroi de fond, une première paire de parois latérales parallèles opposées en matériau diélectrique et une deuxième paire de parois latérales parallèles opposées dont une au moins des parois est constituée par du silicium monocristallin, le traitement de la paroi de fond de l'évidement pour en accroître la vitesse d'oxydation du silicium, la formation sur la paroi de fond et les parois latérales parallèles opposées de la deuxième paire d'une couche d'oxyde de silicium plus épaisse sur la paroi de fond que sur les parois latérales opposées; et la gravure isotrope de l'oxyde de silicium pour éliminer la couche d'oxyde de silicium des parois latérales parallèles opposées de la deuxième paire tout en laissant une couche d'oxyde de silicium sur la paroi de fond de l'évidement.

Dans une seconde réalisation de l'invention, le substrat de l'étape (a) est obtenu à partir d'un substrat dit SOI comprenant :
- un empilement d'une couche inférieure en silicium monocristallin, d'une couche intermédiaire d'oxyde de silicium et d'une couche supérieure comprenant une partie centrale en silicium monocristallin délimité par un isolement latéral;
- la formation sur la couche supérieure d'une couche mince d'oxyde de silicium;
- la formation sur la couche mince d'oxyde de silicium d'un masque;
- la gravure à travers le masque de la couche mince d'oxyde de silicium et de la partie centrale de la couche supérieure du substrat SOI avec arrêt sur la couche intermédiaire d'oxyde de silicium pour former un évidement ayant une paroi de fond en oxyde de silicium et une première paire de parois latérales parallèles opposées en matériau diélectrique et une deuxième paire de parois latérales parallèles opposées dont une au moins est constituée de silicium monocristallin; et
- l'élimination du masque.

De préférence, les parois latérales parallèles opposées en matériau diélectrique de la première paire de parois latérales sont constituées par des parois de l'isolation latérale, généralement en oxyde de silicium (SiO₂).

De préférence, lorsqu'une des parois latérales de la deuxième paire de parois latérales n'est pas constituée de silicium monocristallin, cette paroi latérale est constituée par une paroi de l'isolation latérale, généralement en oxyde de silicium (SiO₂).

La présente invention concerne également un dispositif comportant un substrat comprenant un corps de silicium monocristallin et un isolement latéral définissant dans le corps une partie centrale. La partie centrale comporte un évidement 3 tel que SiO₂. Ce dispositif se caractérise par le fait qu'il comporte dans l'évidement un réseau de lignes parallèles en silicium monocristallin espacées et isolées entre elles.

De préférence, ces lignes en silicium monocristallin reposent sur une paroi de fond en matériau diélectrique tel que SiO₂ de l'évidement.

De préférence, également, les lignes en silicium monocristallin sont enterrées par rapport à la surface supérieure du corps en silicium monocristallin, c'est-à-dire que les surfaces supérieures de ces lignes se trouvent dans le plan de la surface supérieure du corps en silicium monocristallin ou en dessous de cette surface.

Les espaces entre les lignes de silicium monocristallin peuvent être constitués d'un matériau diélectrique gazeux tel que l'air ou d'un matériau diélectrique solide tel que par exemple SiO₂ ou Si₃N₄.

La largeur des lignes en silicium monocristallin et des espaces interlignes est généralement de 5 à 20 nanomètres.

La suite de la description se réfère aux figures annexées qui représentent respectivement :
Figures 1a à 1c : les principales étapes du procédé de fabrication du réseau de lignes nanométriques en silicium monocristallin selon l'invention ;
Figures 2a à 2e : les principales étapes d'un procédé d'obtention d'un substrat correspondant au substrat de la figure la à partir d'un substrat massif en silicium ; et
Figures 3a à 3c : les principales étapes d'un procédé d'obtention d'un substrat analogue à celui de la figure la à partir d'un substrat SOI classique.

En se référant aux figures, et en particulier aux figures la à lc, on a représenté les étapes de fabrication d'un réseau de lignes nanométriques en silicium monocristallin sur un substrat isolant selon l'invention.

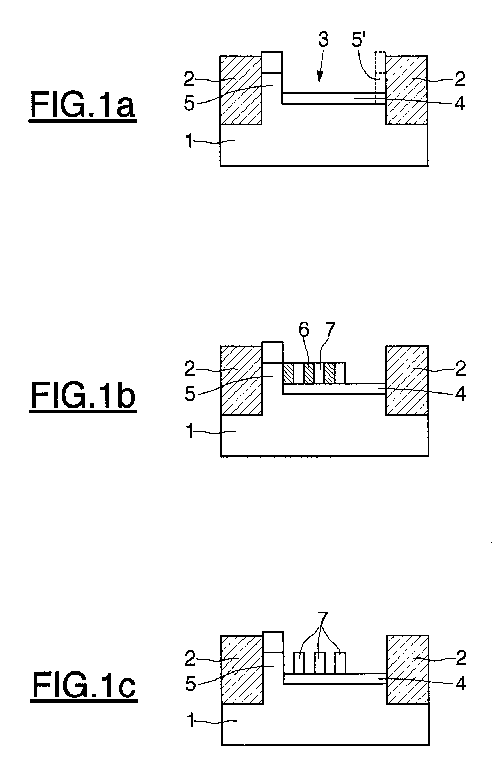

Comme représenté à la figure 1a, la première étape consiste à obtenir un substrat comprenant un corps en silicium monocristallin 1 et un isolement latéral 2 définissant dans le corps une partie centrale. Comme cela est bien connu, l'isolement latéral définit généralement une partie centrale parallélépipédique. Cette partie centrale est pourvue d'un évidement 3, de forme généralement parallélépipédique ayant une paroi de fond horizontale et des parois latérales verticales. La paroi de fond de l'évidement 3 est revêtue d'une couche d'oxyde de silicium 4. Une paroi latérale de l'évidement 3 est définie par une couche de silicium monocristallin 5 cependant que la paroi latérale verticale opposée peut être constituée par une paroi de l'isolement latéral 2 ou par une couche verticale 5' (représentée en pointillés sur la figure 1a) analogue à la couche 5. La couche verticale 5 et éventuellement la couche verticale 5' en silicium monocristallin sont revêtues généralement à leur surface supérieure d'une mince couche d'oxyde de silicium.

Les deux autres parois latérales opposées de l'évidement sont constituées d'un matériau diélectrique et de préférence par une paroi de l'isolement latéral 2.

On procède alors, comme le montre la figure 1b, à la croissance épitaxiale à partir de la paroi latérale verticale en silicium monocristallin 5 de lignes parallèles alternées en alliage de silicium et germanium 6 et en silicium monocristallin 7 dans l'évidement 3 sur la couche d'oxyde de silicium 4. On peut utiliser pour la croissance épitaxiale des lignes alternées, tout procédé classique. Bien évidemment, en fonction des conditions des croissances épitaxiales, on peut régler la largeur des lignes ainsi que le pas des lignes alternées. Cette formation de lignes alternées peut s'effectuer de manière à remplir partiellement ou totalement l'évidement 3.

Les alliages silicium / germanium utiles dans la présente invention sont bien connus. Parmi ces alliages, on peut citer les alliages Si_{1-X}Ge_{X} où 0 < x < 1 et les alliages Si_{1-x-y}Geₓ C_{y} où 0 < x ≤ 0,95 et 0 < y ≤ 0,5. De préférence, on choisira pour des raisons de facilité de la gravure sélective des alliages SiGe ayant un taux relativement élevé en germanium, de préférence des alliages pour lesquels x ≥ 0,1 par exemple 0,1 ≤ x ≤ 0,3.

L'étape finale du procédé consiste en une gravure sélective des lignes en alliage SiGe soit par gravure par plasma isotrope soit par gravure au moyen d'une chimie oxydante bien connue. A titre d'exemple, on peut utiliser une solution de gravure sélective telle qu'une solution de 40 ml HNO₃ 70 % + 1 ml H₂O₂ + 5 ml HF 0,5 %.

Les alliages SiGe ainsi que leur gravure sélective sont décrits dans le brevet français No. 99 03470.

Le substrat décrit à la figure la peut être, comme indiqué précédemment, obtenu soit à partir d'un substrat de silicium monocristallin massif classique, soit d'un substrat dit SOI (silicium sur isolant) classique.

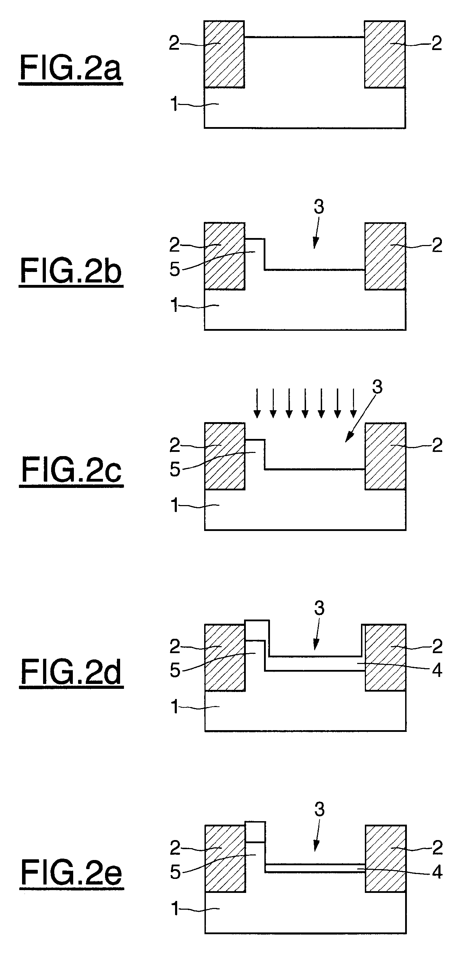

On a représenté aux figures 2a à 2e, les principales étapes d'obtention d'un substrat tel que représenté à la figure la à partir d'un substrat de silicium monocristallin massif classique.

Comme cela est bien connu, le substrat de silicium monocristallin massif classique comprend un corps en silicium monocristallin 1 et un isolement latéral (STI) définissant dans ce corps une partie centrale.

Comme le montre la figure 2b, on commence par former de manière classique au moyen d'un masque et par gravure, un évidement 3 dans la partie centrale du corps de silicium monocristallin 1 de manière à laisser sur une paroi latérale de l'isolement 2 délimitant la partie centrale une partie 5 de silicium monocristallin. La paroi latérale parallèle opposée de l'évidement peut être constituée soit directement comme le montre la figure 2b par l'isolement latéral 2 soit par une partie en silicium analogue à la partie 5.

On procède ensuite comme le montre la figure 2c au traitement de la paroi de fond de l'évidement 3 de manière à modifier cette paroi de fond en silicium monocristallin et lui impartir une vitesse d'oxydation plus importante que la partie verticale 5 en silicium monocristallin constituant une des parois latérales de l'évidement 3. Ce traitement peut être avantageusement une implantation à forte dose d'un élément ou composé approprié. Parmi les éléments appropriés favorisant la vitesse d'oxydation du silicium monocristallin, on peut citer le silicium, l'indium et l'arsenic. Parmi les composés, on peut citer le fluorure de bore BF₂. Cette implantation s'effectue perpendiculairement à la paroi de fond de l'évidement 3 de manière à ne modifier que cette dernière et non la paroi verticale 5 de l'évidement.

Ce procédé de modification de la vitesse de croissance d'oxyde d'une surface en silicium monocristallin est connu et est décrit, par exemple, dans l'article de M. JURCZAK et al. "Investigation on the suitability of vertical MOSFET's for high speed (RF) CMOS applications", actes de l'ESSDERC 1998, pp. 172-175, Editions Frontières, Bordeaux 1998.

La structure obtenue à l'étape 2c est alors soumise à une oxydation classique comme le montre la figure 2d pour former sur la paroi de fond et les parois latérales de l'évidement 3, une couche d'oxyde de silicium 4. En raison du traitement précédent, la couche ainsi formée est plus épaisse sur la paroi de fond de l'évidement que sur les parois latérales de l'évidement, en particulier que sur la paroi en silicium monocristallin non traitée 5 et la paroi latérale opposée de l'évidement. Bien évidemment, la surface supérieure de la paroi latérale 5 en silicium monocristallin est également recouverte d'une couche d'oxyde de silicium d'épaisseur analogue à celle recouvrant la paroi de fond de l'évidement puisque cette surface se trouve également traitée lors du traitement précédent.

On procède alors à l'élimination par gravure, par exemple une gravure chimique classique de la couche d'oxyde de silicium recouvrant les parois latérales opposées de l'évidement. Etant donné que la couche d'oxyde de silicium 4 recouvrant la paroi de fond de l'évidement 3 est plus épaisse que celle recouvrant les parois latérales opposées de cet évidement, l'étape de gravure permet de mettre à nu les parois latérales opposées de l'évidement et en particulier la paroi constituée par la partie 5 en silicium monocristallin tout en conservant sur la paroi de fond de l'évidement une couche d'oxyde de silicium et ainsi d'obtenir le substrat tel que représenté à la figure 1a.

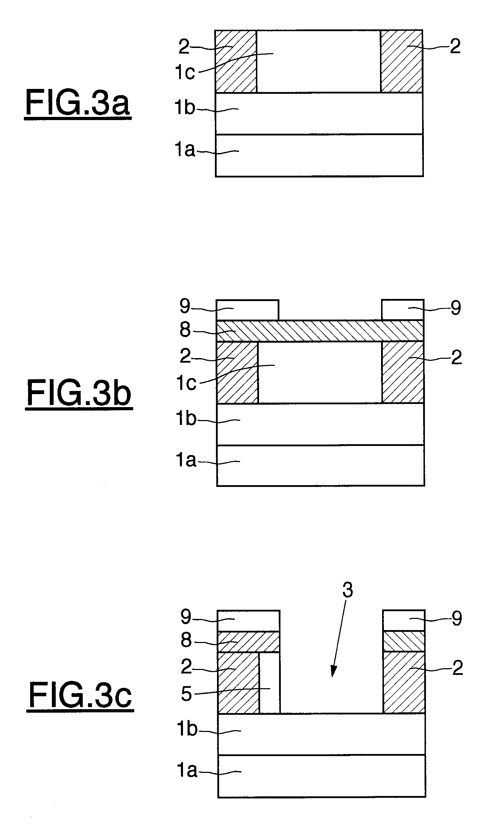

En se référant aux figures 3a à 3c, on va maintenant décrire l'obtention d'un substrat tel que représenté à la figure la à partir d'un substrat dit SOI classique.

Comme le montre la figure 3a, le substrat SOI classique comprend un empilement d'une couche inférieure en silicium monocristallin 1a, d'une couche intermédiaire en oxyde de silicium 1b et d'une couche supérieure constituée par une partie centrale en silicium monocristallin 1c délimitée par un isolement latéral 2.

On commence par former sur la couche supérieure une mince couche d'oxyde de silicium 8 puis sur cette couche de silicium, un masque de résine 9.

Comme le montre la figure 3b, le masque 9 présente une ouverture excentrée par rapport à la partie centrale 1c de manière à recouvrir une portion de la partie centrale en silicium monocristallin 1c adjacente à une paroi latérale de l'isolement 2. On procède alors à la gravure au moyen du masque de la couche mince d'oxyde de silicium 8 et de la partie centrale en silicium monocristallin 1c avec arrêt de gravure sur la couche d'oxyde de silicium intermédiaire 1b pour former un évidement 3 dont la paroi de fond est constituée par de l'oxyde de silicium (oxyde de silicium de la couche intermédiaire 1b) et dont deux parois latérales opposées sont constituées pour l'une de la partie en silicium monocristallin 5 non gravée car sous une partie du masque 9 et par l'isolement latéral 2.

Après élimination du masque 9 de manière classique, on obtient un substrat analogue à celui décrit en liaison avec la figure la.

Bien évidemment, dans les procédés décrits en liaison aux figures 2a à 2e et 3a à 3c, il est possible également de réaliser deux parois latérales opposées de l'évidement 3 constituées de silicium monocristallin en prévoyant un masque de gravure de forme appropriée.

## Revendications

1. Procédé de fabrication d'un réseau de lignes nanométriques en silicium monocristallin sur un substrat isolant caractérisé en ce qu'il comprend :
(a) l'obtention d'un substrat comprenant un corps de silicium (1), un isolement latéral (2) définissant dans le corps (1) une partie centrale, un évidement (3) formé dans la partie centrale ayant une paroi de fond en matérieu diélectrique, de préférence SiO₂, une première paire de parois latérales parallèles opposées en matériau diélectrique, de préférence SiO₂, et une deuxième paire de parois latérales parallèles opposées, au moins une des parois latérales parallèles opposées de la deuxième paire étant constituée par du silicium monocristallin (5) ;
(b) la croissance par épitaxie dans l'évidement (3), à partir de la paroi latérale en silicium monocristallin (5) de l'évidement, d'un réseau alterné de lignes parallèles en alliage SiGe monocristallin (6) et en silicium monocristallin (7) ; et
(c) la gravure des lignes en alliage SiGe monocristallin (7), pour former dans l'évidement (3) un réseau de lignes parallèles en silicium monocristallin (7) isolées les unes des autres.

2. Procédé selon la revendication 1, caractérisé en ce que les deux parois latérales parallèles opposées de la deuxième paire de parois latérales de l'évidement sont constituées par du silicium monocristallin (5, 5') et en ce que la croissance épitaxiale des lignes alternées (6, 7) s'effectue à partir des deux parois latérales parallèles opposées en silicium monocristallin.

3. Procédé selon la revendication 1 ou 2, caractérisé en ce que les lignes alternées (6, 7) ont une largeur inférieure à 100 nm.

4. Procédé selon la revendication 3, caractérisé en ce que les lignes alternées (6, 7) ont une largeur de 5 à 20nm.

5. Procédé selon l'une quelconque des revendications précédentes, caractérisé en ce que l'obtention du substrat de l'étape (a) comprend :
- l'obtention d'un substrat massif en silicium monocristallin (1) comportant un isolement latéral (2) définissant une partie centrale du substrat massif ;
- le masquage et la gravure de la partie centrale pour y former un évidement (3) ayant une paroi de fond, une première paire de parois latérales parallèles opposées en matériau diélectrique et une deuxième paire de parois latérales parallèles opposées dont une au moins des parois est constituée par du silicium monocristallin (5) ;
- le traitement de la paroi de fond de l'évidement pour en accroître la vitesse d'oxydation du silicium ;
- la formation sur la paroi de fond et les parois latérales parallèles opposées de la deuxième paire d'une couche d'oxyde de silicium (4) plus épaisse sur la paroi de fond que sur les parois latérales opposées; et
- la gravure isotrope de l'oxyde de silicium pour éliminer la couche d'oxyde de silicium des parois latérales parallèles opposées de la deuxième paire tout en laissant une couche d'oxyde de silicium sur la paroi de fond de l'évidement (3).

6. Procédé selon la revendication 4, caractérisé en ce que l'étape de traitement de la paroi de fond comprend une implantation verticale d'une dose élevée d'un élément ou d'un composé accélérant l'oxydation du silicium monocristallin.

7. Procédé selon la revendication 6, caractérisé en ce que les éléments sont choisis parmi Si, In et As et le composé est BF₂.

8. Procédé selon l'une quelconque des revendications 1 à 4, caractérisé en ce que l'obtention du substrat de l'étape (a) comprend :
- l'obtention d'un substrat dit SOI comprenant un empilement d'une couche inférieure en silicium monocristallin (1a), d'une couche intermédiaire d'oxyde de silicium (1b) et d'une couche supérieure comprenant une partie centrale en silicium monocristallin (1c) délimité par un isolement latéral (2) ;
- la formation sur la couche supérieure d'une couche mince d'oxyde de silicium (8) ;
- la formation sur la couche mince d'oxyde de silicium (8) d'un masque (9) ;
- la gravure à travers le masque (9) de la couche mince d'oxyde de silicium (8) et de la partie centrale (1c) de la couche supérieure du substrat SOI avec arrêt sur la couche intermédiaire d'oxyde de silicium (1b) pour former un évidement (3) ayant une paroi de fond en oxyde de silicium, une première paire de parois latérales parallèles opposées en matériau diélectrique et une deuxième paire de parois latérales parallèles opposées dont une au moins est constituée de silicium monocristallin (5) ; et
- l'élimination du masque (9).

9. Dispositif comportant un substrat comprenant un corps de silicium monocristallin (1) et un isolement latéral (2) définissant dans le corps une partie centrale, caractérisé en ce que la partie centrale du corps (1) comporte un évidement (3) et dans cet évidement un réseau de lignes parallèles en silicium monocristallin (7) espacées et isolées entre elles.

10. Dispositif selon la revendication 9, caractérisé en ce que l'évidement comporte une paroi de fond (4) en matériau diélectrique et que les lignes (7) du réseau reposent sur cette paroi de fond.

11. Dispositif selon la revendication 10, caractérisé en ce que la paroi de fond (4) est en SiO₂.

12. Dispositif selon l'une quelconque des revendications 9 à 11, caractérisé en ce que le réseau de lignes (7) est enterré.

13. Dispositif selon l'une quelconque des revendications 9 à 12, caractérisé en ce que les lignes (7) du réseau sont isolées entre elles par un matériau diélectrique gazeux ou solide.

14. Dispositif selon l'une quelconque des revendications 9 à 13, caractérisé en ce que les lignes (7) en silicium monocristallin ont une largeur de 5 à 20 nm.
